# EUROPÄISCHE PATENTSCHRIFT

(11) **EP 1 095 455 B1**
(45) Veröffentlichungstag und Bekanntmachung des Hinweises auf die Patenterteilung: **16.01.2002**
(21) Anmeldenummer: 99910129.8
(22) Anmeldetag: 10.02.1999
(51) Int. Cl.: H03K 17/687, H03K 17/785, H03K 17/689

(54) **ELEKTRONISCHER WECHSELSPANNUNGSSCHALTER**
ELECTRONIC ALTERNATING VOLTAGE SWITCH
COMMUTATEUR ELECTRONIQUE POUR TENSIONS ALTERNATIVES

(30) Priorität: 07.07.1998 DE 29812092 U
(43) Veröffentlichungstag der Anmeldung: 02.05.2001
(73) Patentinhaber: IC-HAUS GmbH, D-55294 Bodenheim (DE)
(72) Erfinder: HERZ, Manfred, D-55130 Mainz (DE)
(74) Vertreter: Kampfenkel, Klaus, Dipl.-Ing.
(86) Internationale Anmeldenummer: DE9900385
(87) Internationale Veröffentlichungsnummer: WO0003483

(56) Entgegenhaltungen:
- EP-A- 0 637 875
- FR-A- 2 463 543
- FR-A- 2 688 363
- US-A- 4 902 901
- US-A- 5 640 344

## Beschreibung

Die Erfindung betrifft einen elektronischen Wechselspannungsschalter gemäß dem Oberbegriff des Anspruchs 1.

Zum Schalten von großen Wechselspannungen (z. B. 60V) oder hohen Wechselsströmen (größer als 1 A) werden vornehmlich mechanische Wechselspannungsschalter verwendet. Da aber die Elektronik in zahlreiche Bereiche, so auch in den Automobilbereich erfolgreich Einzug genommen hat, besteht ein Bedürfnis daran, elektronische Wechselspannungsschalter für hohe Leistungen zu entwickeln.

Ein elektronischer Wechselspannungsschalter, wie im Oberbegriff des Anspruchs 1 angegeben, ist aus der FR-A-2 688 363 bekannt.

Der Erfindung liegt daher die Aufgabe zugrunde, einen elektronischen Wechselspannungsschalter zu schaffen, der für hohe Leistungen ausgelegt ist und mit möglichst geringer Energie betrieben werden kann.

Dieses technische Problem löst die Erfindung mit den Merkmalen des Anspruchs 1.

Hierzu bieten sich ladungsabhängige und leistungslos ansteuerbare MOS-Transistoren an. Erfindungsgemäß weist der elektronische Wechselspannungsschalter zwei in Reihe geschaltete MOS-Transistoren auf, derart, daß diese eine angelegte Wechselspannung sperren und durchlassen können. Mit anderen Worten können die in Reihe geschalteten MOS-Transistoren in einen hochohmigen und in einen niederohmigen Zustand gesteuert werden. Wenigstens eine Einrichtung zur Speicherung von Ladungen, die als Floating-Gate ausgebildet ist, steht mit den Gateanschlüssen der MOS-Transistoren in Verbindung. Darüber hinaus ist jeder Ladungsspeichereinrichtung zum Aufbringen einer vorbestimmten Ladungsmenge auf die Ladungsspeichereinrichtungen, die einem ersten Schaltzustand entspricht, und zum Entfernen einer vorbestimmten Ladungsmenge von den Ladungsspeichereinrichtungen, die einem zweiten Schaltzustand entspricht, eine Ladungs-Speiseeinrichtung zugeordnet.

Um einen elektronischen Wechselspannungsschalter kostengünstig herstellen zu können, kann auf an sich bekannte Bauelemente, die mit einem Floating-Gate als LadungsSpeichereinrichtung aufgebaut sind, wie zum Beispiel ein Floating-Gate-Feldeffekttransistor, zurückgegriffen werden. Das Floating-Gate ist dabei in ein Oxid gebettet, so daß es als Ladungsspeicher für Ladungen dient, die beispielsweise über den Tunneleffekt aufgebracht werden. Floating-Gate Feldeffekttransistoren werden unter anderem in großer Anzahl als Speicherzellen in elektrisch löschbaren, programmierbaren Nur-Lese-Speicher (Electrically Erasable Programmable Read Only Memories, EEPROM) verwendet. Auf diese Weise kann der Schaltzustand des elektronischen Wechselspannungsschalters auch ohne permanentes Anlegen einer externen Spannungsquelle gehalten oder gespeichert werden.

Vorteilhafte Weiterbildungen sind in den Unteransprüchen angegeben.

Bei einer Ausführungsform sind zwei MOS-Transistoren vom n-Kanal-Typ derart in Reihe gegeneinander geschaltet, daß die Sourceanschlüsse der MOS-Transistoren die Anschlußklemmen des elektronischen Wechselspannungsschalters bilden. Die MOS-Transistoren haben demnach einen gemeinsamen Drain-anschluß. Weiterhin ist jedem MOS-Transistor ein separates Floating-Gate zugeordnet, dem jeweils eine Ladungs-Speiseeinrichtung zugeordnet ist.

Um den Aufbau des Wechselspannungsschalters weiter vereinfachen und damit die Herstellungskosten verringern zu können, sind zwei MOS-Transistoren vom n-Typ derart in Reihe geschaltet, daß die Drainanschlüsse der MOS-Transistoren die Anschlußklemmen des elektronischen Wechselspannungsschalters bilden. Dadurch haben die MOS-Transistoren einen gemeinsamen Sourceanschluß und können mit einem gemeinsamen Oxid hergestellt werden. Demzufolge wird auch nur noch eine Ladungs-Speiseeinrichtung benötigt.

Als Ladungs-Speiseeinrichtungen können gewöhnliche, extern anschaltbare Spannungsquellen zum Einsatz kommen.

Da aber zum Schalten des elektronischen Wechselspannungsschalters in MOS-Technologie nur geringe Ladungsmengen notwendig sind und die Dauer der Einschaltprozesse unbedeutend ist, können Ladungs-Speiseeinrichtungen verwendet werden, die nur kleine Ströme erzeugen.

Eine solche Einrichtung kann als optoelektronisches Bauteil ausgebildet sein, das einfallendes Licht in einen elektrischen Strom umsetzt.
Beispielsweise umfaßt das optoelektronische Bauteil wenigstens eine erste Fotodiode, wie z. B. eine PIN-Diode, mit einer ersten wellenlängenabhängigen Empfindlichkeit, und wenigstens eine zur ersten Fotodiode parallel geschaltete zweite Fotodiode mit einer zweiten wellenlängenabhängigen Empfindlichkeit, wobei die erste Fotodiode und die zweite Fotodiode entgegengesetzt gepolt sind. In Abhängigkeit von der Wellenlänge des eingestrahlten Lichtes werden Ladungen auf die Floating-Gates aufgebracht oder von diesem entfernt und somit der Schaltzustand des elektronischen Wechselspannungsschalters festgelegt. Als Lichtquellen können Laserdioden oder LEDs, die Licht mit den entsprechenden Wellenlängen erzeugen, verwendet werden. Durch den Einsatz von Fotodioden als Ladungs-Speiseeinrichtung ist es möglich, den elektronischen Wechselspannungsschalter zusammen mit der Ladungs-Speiseeinrichtung als integrierten Baustein herzustellen.

Die Ladungs-Speiseeinrichtung läßt sich alternativ auch durch eine mechanisch-/elektrische Einrichtung ausführen, die beispielsweise eine Anzahl von piezoelektrischen Elementen umfaßt. Die piezoelektrischen Elemente sind parallel zueinander geschaltet und entgegengesetzt gepolt und liegen in Reihe zu den MOS-Transistoren. Parallel zu den piezoelektrischen Elementen liegen zur Spannungsbegrenzung und damit zum Schutz des Gates zwei gegeneinander geschaltete Zener-Dioden. In dieser Aus-führungsform wird der Schaltzustand des Wechselspannungsschalter durch mechanisches Verformen eines der beiden piezoelektrischen Elemente gesteuert.
Die Steuerung des Schaltzustandes erfolgt dadurch, daß durch mechanischen Druck auf das eine piezoelektrische Element Ladungen zu den Floating-Gates gelangen und durch Krafteinwirkung auf das andere piezoelektrische Element Ladungen von den Floating-Gates entfernt werden.

Diese Möglichkeit der Ladungsversorgung wird wiederum durch den geringen Bedarf des elektronischen Wechselspannungsschalters an Ladungsträgern eröffnet. Ein piezoelektrisches Element kann nur sehr geringe Ströme bereitstellen, was bei dieser Anwendung aber ausreichend ist.

Die Erfindung wird nachfolgend anhand der Ausführungsbeispiele in Verbindung mit den beiliegenden Zeichnungen näher erläutert. Es zeigen darin:
- Fig.1: das elektrische Ersatzschaltbild eines beispielhaften elektronischen Wechselspannungsschalters,
- Fig. 2: das elektrische Ersatzschaltbild eines weiteren beispielhaften elektronischen Wechselspannungsschalters,
- Fig. 3: eine alternative Ausführungsform der in Fig. 2 gezeigten Ladungs-Speiseeinrichtung,
- Fig. 4: ein Diagramm des wellenlängenabhängigen Intensitätsverlaufs der in Fig. 3 gezeigten Diodenanordnung,
- Fig. 5: eine weitere alternative Ausführungsform für die in Fig. 2 gezeigte Ladungs-Speiseeinrichtung.

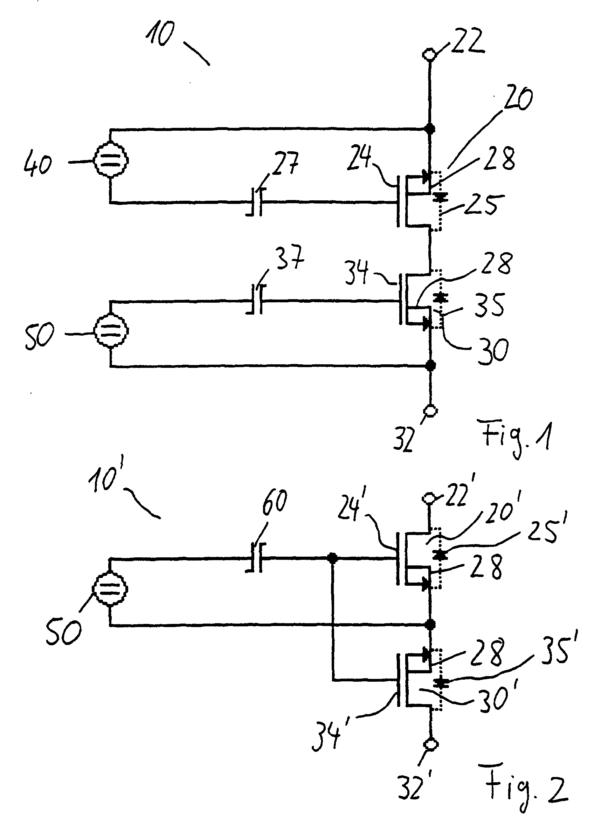

In Fig. 1 ist ein elektronischer Wechselspannungsschalter 10 dargestellt, der zwei in Reihe geschaltete MOS-Transistoren vom n-Typ 20, 30 aufweist. Jeder MOS-Transistor weist in an sich bekannter Weise eine Source- und Drainzone, ein dazwischenliegendes Bulkgebiet 28 und eine Gatezone auf. Die MOS-Transistoren 20 und 30 sind über ihre Drain-Elektroden miteinander verbunden, so daß die jeweiligen Sourceanschlüsse 22 bzw. 32 der MOS-Transistoren 20 bzw. 30 die Anschlußklemmen des elektronischen Wechselspannungsschalters 10 darstellen, an die die zu schaltende Wechselspannung angelegt werden kann. Jeder MOS-Transistor ist ähnlich einer EEPROM-Zelle aufgebaut, d.h. jeder MOS-Transistor 20, 30 enthält als Ladungsspeichereinrichtung ein Floating-Gate 24 bzw. 34, die beispielsweise über ein Tunneloxid ge- bzw entladen werden können. Aufgrund des Herstellungsprozesses bildet sich bei der Verbindung des Bulkgebietes 28 mit der Sourcezone des jeweiligen Transistors 20, 30 parallel zum Drain-Source-Kanal eine parasitäre Diode 25 bzw. 35, deren Anode jeweils mit dem Sourceanschluß und deren Kathode jeweils mit dem Drainanschluß des jeweiligen MOS-Transistors verbunden ist. Infolge der gewählten Reihenschaltung der MOS-Transistoren 20, 30 mit einem gemeinsamen Drainanschluß sind die Dioden 25 und 35 gegeneinander geschaltet. Zum Aufbringen von Ladungen auf die Floating-Gates 24 und 34 ist jeweils eine Spannungsquelle 40 bzw. 50 vorgesehen. Da der Prozeß des Aufbringens von Ladungen auf ein bzw. des Entfernens von Ladungen von einem Floating-Gate an sich bekannt ist, wird hierauf nicht näher eingegangen. Dank der Verwendung von zwei MOS-Transistoren 20, 30 erfolgt die Ansteuerung des elektronischen Wechselspannungsschalters 10 ladungsabhängig und leistungslos. Da jedem MOS-Transistor ein Floating-Gate zugeordnet ist, kann der Schaltungszustand auch dann aufrecht erhalten werden, wenn die externe Spannungsquelle 40 bzw. 50 abgeschaltet ist.

Nachfolgend wird kurz die Funktionsweise des elektronischen Wechselspannungsschalters nach Fig. 1 beschrieben.

Durch Aufbringen einer vorbestimmten Ladungsmenge auf das Floating-Gate 24 des MOS-Transistors 20 mittels der Spannungsquelle 40 und auf das Floating-Gate 34 des MOS-Transistors 30 über die Spannungsquelle 50 werden die beiden MOS-Transistoren 20 und 30 in einen leitenden, d.h. niederohmigen Zustand versetzt. Eine an die Anschlußklemmen 22 und 32 angelegte Wechselspannung wird somit durchgeschaltet. Selbst wenn die Spannungsquellen 40 und 50 auf 0 Volt gesetzt werden, bleibt der geschlossene Schalterzustand aufgrund der in dem jeweiligen Floating-Gate 24, 34 gespeicherten Ladungen aufrechterhalten. Das Abführen der Ladungen von den Floating-Gates 24 und 34 erfolgt beispielsweise mittels des Tunneleffekts durch Umpolung der Ladungs-Speiseeinrichtungen. Durch diesen Entladevorgang der beiden Floating-Gates 24 und 34 werden die MOS-Transistoren 20 bzw. 30 in einen hochohmigen Zustand geschaltet. Der elektronische Wechselspannungsschalter 10 sperrt somit eine angelegte Wechselspannung. In diesem Fall ist die Source-Drain-Strecke jedes MOS-Transistors hochohmig und die beiden Anschlußklemmen 22 und 32 sind über die parasitären Dioden 25 und 35 miteinander verbunden. Da die Dioden 25, 35 jedoch gegenpolig verschaltet sind, bleibt der elektronische Wechselspannungsschalter 10 für eine angelegte Wechselspannung hochohmig.

Fig.2 zeigt einen gegenüber dem in Fig. 1 dargestellten elektronischen Wechselspannungsschalter 10 weiter vereinfachten Wechselspannungsschalter 10', der wiederum zwei in Reihe geschaltete MOS-Transistoren 20' und 30', vom n-Typ aufweist, die aber diesmal eine gemeinsame Source-Elektrode aufweisen.
In diesem Fall bilden die Drain-Elektroden der MOS-Transistoren die Anschlußklemmen 22' und 32' für den elektronischen Wechselspannungsschalter 10'. Ein weiterer Unterschied zu dem in Fig. 1 gezeigten elektronischen Wechselspannungsschalter 10 besteht darin, daß der elektronische Wechselspannungsschalter 10' lediglich eine einzige Tunnelstrecke 60 enthält, die den beiden MOS-Transistoren 20' und 30' zugeordnet ist. Demzufolge ist auch nur noch eine Spannungsquelle 50 zum Aufbringen von Ladungen auf die jeweiligen Floating-Gates 24' und 34' notwendig.

Wiederum bilden sich bei der Herstellung des elektronischen Wechselspannungsschalters 10' in den MOS-Transistoren 20' und 30' parasitäre Dioden 25' bzw. 35' aus, die infolge des gemeinsamen Sourceanschlusses der beiden MOS-Transistoren 20' und 30' entgegengesetzt zueinander gepolt sind. Die Funktionsweise des elektronischen Wechselspannungsschalters 10' entspricht der Funktionsweise des in Fig. 1 gezeigten elektronischen Wechselspannungsschalters 10, wobei anstelle von zwei Tunnelstrecken nur noch eine gemeinsame Tunnelstrecke 60 verwendet wird.

Der Ersatz mechanischer Wechselspannungsschalter durch den hier beschriebenen elektronischen Wechselspannungsschalter 10 oder 10' gelingt insbesondere dann, wenn ein niedriger Innenwiderstand im Ein-Zustand und eine hohe Sperrspannung im Aus-Zustand erreicht werden kann. Beide Forderungen werden durch die Realisierung der MOS-Transistoren als DMOS-Typ in einem BCD (Bipolar-CMOS-DMOS)-Prozeß erfüllt.

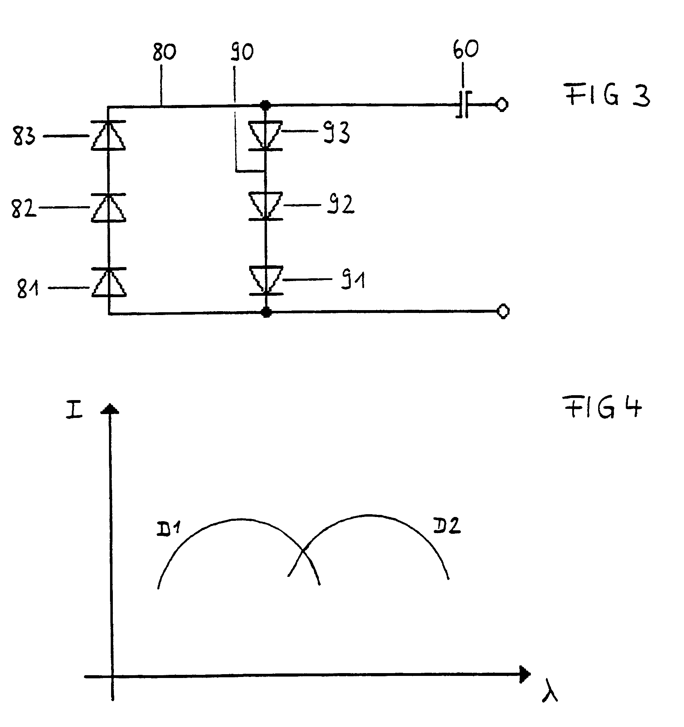

In Fig. 3 ist eine alternative Ausführungsform zum Aufbringen einer Ladungsmenge auf die Floating-Gates 24' und 34' des in Fig. 2 gezeigten Wechselspannungsschalters 10' dargestellt. Anstelle der elektrischen Ansteuerung des Wechselspannungsschalters 10' mittels der Spannungsquelle 50 wird die Ladung mittels Lichteinkopplung über die Tunnelstrecke 60 auf die Floating-Gates 24' und 34' aufgebracht. Dazu wird eine optoelektronische Ladungs-Speiseeinrichtung 70 vorgeschlagen, die beispielsweise zwei parallel geschaltete Fotodiodenanordnungen 80 und 90 umfaßt. Die Fotodiodenanordnung 80 enthält beispielsweise drei hintereinander geschaltete Fotodioden 81, 82 und 83, deren maximale Lichtempfindlichkeit beispielsweise im roten Wellenlängenbereich liegt. Der Tunnelstrecke 60 ist der Kathodenanschluß der Fotodiode 83 zugeordnet, während der Anodenanschluß der Fotodiode 83 mit dem Kathodenanschluß der Fotodiode 82 verbunden ist. Der Anodenanschluß der Fotodiode 82 ist mit dem Kathodenanschluß der Fotodiode 81 verbunden, deren Anodenanschluß auf Bezugspotential liegt. Die Fotodiodeneinrichtung 90 umfaßt ebenfalls drei Fotodioden 91, 92 und 93, die jedoch mit Bezug auf die Fotodioden 81, 82 und 83 in entgegengesetzter Durchlaßrichtung angeschlossen sind. Die Lichtempfindlichkeit der Fotodioden 91, 92 und 93 liegt beispielsweise im infraroten Wellenlängenbereich. Bei den Fotodioden handelt es sich vorteilhafterweise um Halbleiterdioden, wie zum Beispiel um Pin-Dioden, so daß neben dem Wechselspannungsschalter 10' auch wenigstens ein Teil der Ladungs-Speiseeinrichtung 70 in einem integrierten Baustein herstellbar ist. Der wellenlängenabhängige Empfindlichkeitsbereich der Fotodiodenanordnungen 80 und 90 ist in Fig. 4 dargestellt. In Figur 4 bezeichnet die Abszisse die Wellenlänge des eingestrahlten Lichtes, die Ordinate bezeichnet die Stromstärke. Der mit D1 bezeichnete Kurvenverlauf gehört zur Fotodiodenanordnung 80, wohingegen der mit D2 bezeichnete Kurvenverlauf zur Fotodiodenanordnung 90 gehört.
Der Ersatz der herkömmlichen elektrischen Spannungsquelle 50 durch eine elektrooptische Ladungs-Speiseeinrichtung 70 ist möglich, da der elektronische Wechselspannungsschalter 10 oder 10' zum Ändern des Schaltzustandes nur wenig Ladung benötigt und die Dauer des Einschaltprozesses zeitunkritisch ist. Zum Aufbringen von Ladungen auf die Floating-Gates 24' und 34' wird die Fotodiodenanordnung 90 mit Infrarot-Licht bestrahlt. Der Wechselspannungsschalter 10' befindet sich nunmehr im eingeschalteten, d. h. niederohmigen Zustand. Zum Entladen der Floating-Gates 24' und 34' wird die Fotodiodenanordnung 80 mit rotem Licht bestrahlt. Die MOS-Transistoren 20' und 30' werden nunmehr in einen sperrenden Zustand versetzt, so daß die beiden Anschlußklemmen 22' und 32' über die gegeneinander geschalteten parasitären Dioden 25' und 35' miteinander verbunden sind. Auf diese Weise ist wieder gewährleistet, daß der elektronische Wechselspannungsschalter 10' für eine angelegte Wechselspannung hochohmig bleibt. Da die Fotodioden 91, 92, 93 eine maximale Lichtempfindlichkeit im Infarot-Bereich und die Fotodioden 81, 81, 83 eine maximale Lichtempfindlichkeit im roten Wellenlängenbereich besitzen, ist der Auflade- und Entladevorgang der Floating-Gates 24' und 34' im wesentlichen entkoppelt.

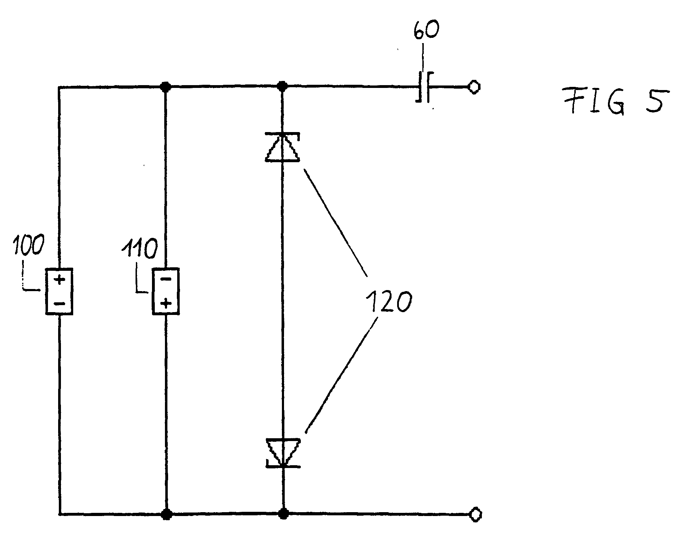

Fig. 5 zeigt eine weitere alternative Ladungs-Speiseeinrichtung, die beispielsweise zwei parallel geschaltete piezoelektrische Elemente 100, 110 umfaßt. Zwei dazu parallel und gegeneinander geschaltete Zehnerdioden 120 dienen als Spannungsbegrenzer, um die Tunnelstrecke 60 und damit den nachgeschalteten elektronischen Wechselspannungsschalter 10' vor Spannungsspitzen zu schützen. Ein Aufbringen auf die und Entfernen von Ladungen von den Floating-Gates 24' und 34' wird in diesem Beispiel druckgesteuert durch Verformen der entsprechenden piezoelektrischen Elemente 100, 110 bewirkt.

## Patentansprüche

1. Elektronischer Wechselspannungsschalter mit folgenden Merkmalen:
zwei in Reihe geschaltete MOS-Transistoren (20, 30; 20', 30'), derart, daß diese eine angelegte Wechselspannung sperren und durchlassen können,
wenigstens eine, mit den Gateanschlüssen der MOS-Transistoren in Verbindung stehende Einrichtung (24, 27, 34, 37; 24', 34', 60) zur Speicherung von Ladungen, wobei jeder Ladungsspeichereinrichtung (24, 27, 34, 37; 24', 34', 60) eine Ladungs-Speiseeinrichtung (40, 50; 50) zum Aufbringen einer vorbestimmten Ladungsmenge auf die Ladungsspeichereinrichtung (24, 34; 24', 34'), die einem ersten Schaltzustand entspricht, und zum Entfernen einer vorbestimmten Ladungsmenge von der Ladungsspeichereinrichtung, die einem zweiten Schaltzustand entspricht, zugeordnet ist,
**dadurch gekennzeichnet, dass**
die Ladungsspeichereinrichtung (24, 34; 24', 34') ein Floating-Gate ist.

2. Elektronischer Wechselspannungsschalter nach Anspruch 1,
**dadurch gekennzeichnet, daß**
die beiden MOS-Transistoren (20', 30') vom n-Kanal-Typ sind, einen gemeinsamen Sourceanschluß, ein gemeinsames Oxid (60) und jeweils eine Ladungsspeichereinrichtung (24', 34') aufweisen.

3. Elektronischer Wechselspannungsschalter nach Anspruch 1,
**dadurch gekennzeichnet, daß**
die beiden MOS-Transistoren (20, 30) vom n-Kanal-Typ sind, jeweils ein Oxid (27, 37) und einen gemeinsamen Drainanschluß aufweisen, und daß jedem Gateanschluß eine Ladungsspeichereinrichtung (24, 34) zugeordnet ist.

4. Elektronischer Wechselspannungsschalter nach einem der Ansprüche 1 bis 3, **dadurch gekennzeichnet, daß**
die Ladungs-Speiseeinrichtung eine optoelektronische Einrichtung (70) ist.

5. Elektronischer Wechselspannungsschalter nach Anspruch 4,
**dadurch gekennzeichnet, daß**
die optoelektronische Einrichtung (70 eine erste Einrichtung (80), die wenigstens eine Fotozelle (81, 82, 83) mit einer ersten wellenlängenabhängigen Empfindlichkeit umfaßt, und eine zur ersten Einrichtung parallel geschaltete zweite Einrichtung (90), die wenigstens eine Fotozelle (91, 92, 93) mit einer zweiten wellenlängenabhängigen Empfindlichkeit umfaßt, aufweist, wobei die Fotodiode (81, 82, 83) der ersten Einrichtung (80) und die Fotodiode (91, 92, 93) der zweiten Einrichtung (90) entgegengesetzt gepolt sind.

6. Elektronischer Wechselspannungsschalter nach einem der Ansprüche 1 bis 3,
**dadurch gekennzeichnet, daß**
die Ladungs-Speiseeinrichtung eine mechanisch/elektrische Einrichtung (100, 110) ist.

7. Elektronischer Wechselspannungschalter nach Anspruch 6,
**dadurch gekennzeichnet, daß**
die mechanisch-/elektrische Einrichtung wenigstens ein erstes und ein zweites Piezoelement aufweist, die entgegengesetzt gepolt und parallel zueinander geschaltet sind.

8. Elektronischer Wechselspannungsschalter nach einem der Ansprüche 1 bis 7, **dadurch gekennzeichnet, daß**
dieser DMOS-Transistoren enthält und als integrierter Baustein herstellbar ist.

## Claims

1. An electronic AC voltage switch having the following features:
two MOS transistors (20, 30; 20', 30') connected in series such that they can block and transmit an applied AC voltage,
at least one charge-storage device (24, 27, 34, 37; 24', 24', 60) connected to the gate connections of the MOS transistors, wherein each charge-storage device (24, 27, 34, 37; 24', 34', 60) is associated with a charge supply device (40, 50; 50) for supplying a predetermined amount of charge to the charge storage device (24, 34; 24', 34') corresponding to a first switching state and for removing a predetermined quantity of charge from the charge storage device corresponding to a second switching state,
**characterised in that** the charge storage device (24, 34; 24', 34') is a floating gate.

2. An electronic AC voltage switch according to claim 1, **characterised in that** the two MOS transistors (20', 30') are n-channel type and have a common source connection, a common oxide (60), and each has a charge storage device (24', 30').

3. An electronic AC voltage switch according to claim 1, **characterised in that** the two MOS transistors (20, 30) are n-channel type, each have an oxide (27, 37) and a common drain connection, and each gate connection is associated with a charge storage device (24, 34).

4. An electronic AC voltage switch according to any of claims 1 to 3, **characterised in that** the charge storage device is an opto-electronic device (70).

5. An electronic AC voltage switch according to claim 4, **characterised in that** the opto-electronic device (70) comprises a first device (80) containing at least one photocell (81, 82, 83) having a first sensitivity dependent on wavelength and contains a second device (90) connected in parallel to the first device and comprising at least one photocell (91, 92, 93) having a second sensitivity dependent on wavelength, wherein the photodiode (81, 82, 83) of the first device (80) and the photodiode (91, 92, 93) of the second device (90) have opposite polarity.

6. An electronic AC voltage switch according to any of claims 1 to 3, **characterised in that** the charge storage device is a mechanical electrical device (100, 110).

7. An electronic AC voltage switch according to claim 6, **characterised in that** the mechanical electrical device comprises at least a first and a second piezo-element which have opposite polarity and are connected in parallel.

8. An electronic AC voltage switch according to any of claims 1 to 7, **characterised in that** it contains DMOS transistors and can be produced as an integrated component.

## Revendications

1. Commutateur électronique de tension alternative qui présente les caractéristiques suivantes :
deux transistors MOS (20, 30 ; 20', 30') branchés en série de telle sorte que ceux-ci peuvent bloquer ou laisser passer une tension alternative appliquée,
au moins un dispositif (24, 27, 34, 37 ; 24', 34', 60) qui est en liaison avec les bornes de grilles des transistors MOS et qui est destiné à stocker des charges,
dans lequel il est associé à chaque dispositif de stockage de charges (24, 27, 34, 37 ; 24', 34', 60) un dispositif d'introduction de charges (40, 50 ; 50) pour apporter une quantité prédéterminée de charges au dispositif de stockage de charges (24, 34 ; 24', 34') qui correspond à un premier état de commutation et pour enlever une quantité prédéterminée de charges du dispositif de stockage de charges qui correspond à un deuxième état de commutation,
**caractérisé en ce que** le dispositif de stockage de charges (24, 34 ; 24', 34') est une grille flottante.

2. Commutateur électronique de tension alternative selon la revendication 1, **caractérisé en ce que** les deux transistors MOS (20', 30') sont du type de canal n et ont une borne de source commune, un oxyde (60) commun et chacun un dispositif de stockage de charges (24', 34').

3. Commutateur électronique de tension alternative selon la revendication 1, **caractérisé en ce que** les deux transistors MOS (20, 30) sont du type de canal n et ont chacun un oxyde (27, 37) et une borne, de drain commune et **en ce qu'**un dispositif de stockage de charges (24, 34) est associé à chaque borne de grille.

4. Commutateur électronique de tension alternative selon l'une des revendications 1 à 3, **caractérisé en ce que** le dispositif d'introduction de charges est un dispositif optoélectronique (70).

5. Commutateur électronique de tension alternative selon la revendication 4, **caractérisé en ce que** le dispositif optoélectronique (70) comporte un premier dispositif (80), qui comprend au moins une cellule photoélectrique (81, 82, 83) ayant une première sensibilité dépendante de la longueur d'onde, et un deuxième dispositif (90), qui est branché en parallèle avec le premier dispositif et qui comprend au moins une cellule photoélectrique (91, 92, 93) ayant une deuxième sensibilité dépendante de la longueur d'onde, la photodiode (81, 82, 83) du premier dispositif (80) et la photodiode (91, 92, 93) du deuxième dispositif (90) étant polarisées en sens inverse.

6. Commutateur électronique de tension alternative selon l'une des revendications 1 à 3, **caractérisé en ce que** le dispositif d'introduction de charges est un dispositif mécanique/électrique (100, 110).

7. Commutateur électronique de tension alternative selon la revendication 6, **caractérisé en ce que** le dispositif mécanique/électrique comporte au moins un premier élément piézoélectrique et un deuxième élément piézoélectrique qui sont polarisés en sens inverse et qui sont branchés en parallèle l'un par rapport à l'autre.

8. Commutateur électronique de tension alternative selon l'une quelconque des revendications 1 à 7, **caractérisé en ce que** celui-ci contient des transistors DMOS et **en ce qu'**il peut être fabriqué sous forme de composant intégré.
